(19) Europäisches Patentamt
European Patent Office
Office européen des brevets

(11) **EP 1 845 612 A1**

(12) **EUROPÄISCHE PATENTANMELDUNG**

(43) Veröffentlichungstag:
**17.10.2007 Patentblatt 2007/42**

(51) Int Cl.:
***H03C 3/09*** *(2006.01)*

(21) Anmeldenummer: **07007141.0**

(22) Anmeldetag: **05.04.2007**

(84) Benannte Vertragsstaaten:
**AT BE BG CH CY CZ DE DK EE ES FI FR GB GR
HU IE IS IT LI LT LU LV MC MT NL PL PT RO SE
SI SK TR**
Benannte Erstreckungsstaaten:
**AL BA HR MK YU**

(30) Priorität: **13.04.2006  DE 102006017973**

(71) Anmelder: **ATMEL Germany GmbH
74072 Heilbronn (DE)**

(72) Erfinder:
• **Beyer, Sascha, Dipl.-Ing.
D-01458 Ottendorf-Okrilla (DE)**
• **Jaehne, Rolf, Dipl.-Ing.
D-01458 Ottendorf-Okrilla (DE)**

(74) Vertreter: **Patentanwälte
Ruff, Wilhelm, Beier, Dauster & Partner
Kronenstrasse 30
70174 Stuttgart (DE)**

(54) **Frequenzmodulator**

(57)  Die Erfindung betrifft einen Frequenzmodulator zum Generieren eines Ausgangssignals mit einer von einem Modulationssignal abhängigen Frequenz, wobei das Modulationssignal N ≥ 2 unterschiedliche diskrete Modulationswerte annehmen kann und jedem Modulationswert ein vorgegebener Frequenzwert des Ausgangssignals zugeordnet ist, enthaltend a) eine geschlossene Phasenregelschleife mit einem Schleifenfilter zum Bereitstellen einer ersten Steuerspannung, einem spannungsgesteuerten Oszillator zum Generieren des Ausgangssignals und einem schaltbaren Frequenzteiler zum Ableiten eines frequenzgeteilten Signals, und b) eine Modulationseinheit, die ausgebildet ist, an einem ersten Ausgang vom Modulationssignal abhängige Werte eines Teilers und an einem zweiten Ausgang eine vom Modulationssignal abhängige zweite Steuerspannung bereitzustellen, c) wobei der Oszillator einen mit dem Schleifenfilter verbundenen ersten Steuereingang und einen mit dem zweiten Ausgang der Modulationseinheit verbundenen zweiten Steuereingang aufweist und ausgebildet ist, das Ausgangssignal in Abhängigkeit von der ersten Steuerspannung und der zweiten Steuerspannung zu generieren, d) und wobei der Frequenzteiler mit dem ersten Ausgang der Modulationseinheit verbunden und ausgebildet ist, das frequenzgeteilte Signal derart abzuleiten, daß es von den Teilerwerten abhängigen Momentanfrequenzen aufweist. Erfindungsgemäß weist die Modulationseinheit einen kapazitiven Spannungsteiler mit einem Mittelabgriff auf und ist ausgebildet, die zweite Steuerspannung am Mittelabgriff bereitzustellen. Die Erfindung betrifft weiterhin eine Sende/Empfangsvorrichtung und eine integrierte Schaltung mit einem solchen Frequenzmodulator.

FIG. 3

**Beschreibung**

Die vorliegende Erfindung betrifft einen Frequenzmodulator nach dem Oberbegriff des Patentanspruchs 1. Die Erfindung betrifft weiterhin eine Sende-/ Empfangsvorrichtung und eine integrierte Schaltung mit einem solchen Frequenzmodulator.

Die Erfindung liegt auf dem Gebiet diskreter Frequenzmodulatoren für Sende-/ Empfangsvorrichtungen in Kommunikationssystemen. Solche Frequenzmodulatoren generieren ein Ausgangssignal mit einer von einem wertdiskreten Modulationssignal abhängigen Momentanfrequenz, wobei das Modulationssignal $N \geq 2$ unterschiedliche diskrete Modulationswerte annehmen kann und jedem Modulationswert ein vorgegebener Frequenzwert des Ausgangssignals zugeordnet ist.

Die Erfindung liegt insbesondere auf dem Gebiet der sog. direkt modulierenden Frequenzmodulatoren, die das modulierte Ausgangssignal im Rahmen der Frequenzsynthese erzeugen. Sie liegt weiterhin insbesondere auf dem Gebiet der sog. "closed loop" Frequenzmodulatoren, deren Phasenregelschleife (PLL) auch während der Modulation geschlossen ist.

Aus dem in der Fachzeitschrift "IEEE Transactions on Circuits and Systems - II: Analog and Digital Signal Processing", Vol. 49, No. 5, Mai 2002 auf den Seiten 301-311 erschienenen Artikel "Automatic Calibration of Modulated Frequency Synthesizers" von Daniel R. McMahill und Charles G. Sodini ist ein direkt modulierender Frequenzmodulator mit einer geschlossenen Phasenregelschleife bekannt. Hierbei wird der PLL-Synthesizer moduliert, indem der Teilerwert des Frequenzteilers im Rückkopplungszweig der Phasenregelschleife in Abhängigkeit vom Modulationssignal variiert wird.

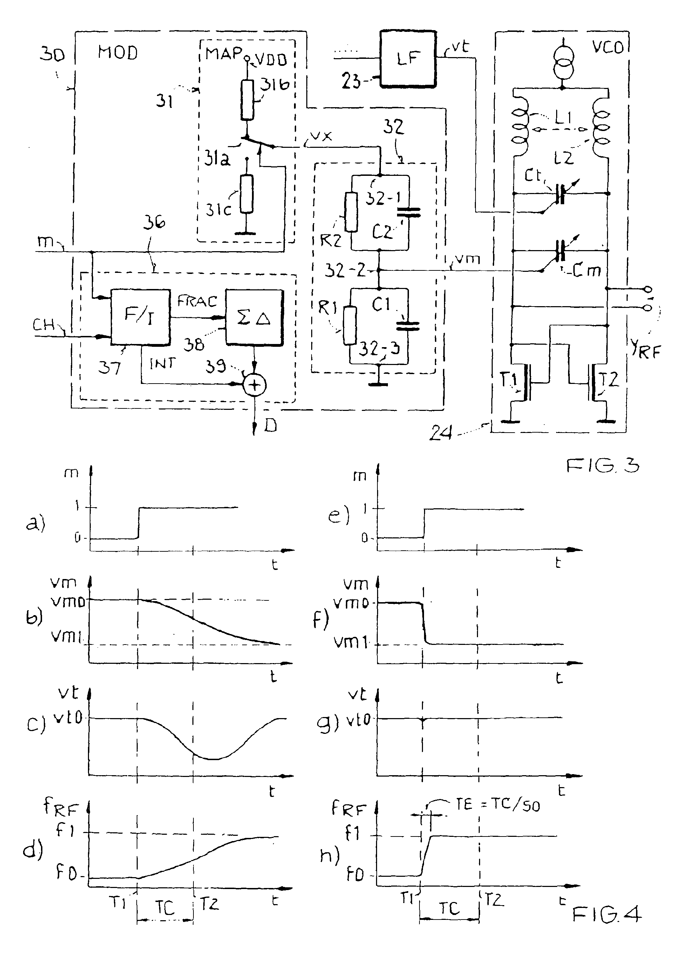

Die Modulationsbandbreite, d.h. die maximal mögliche Rate des Modulationssignals ist bei einem solchen Ansatz allerdings durch die Bandbreite der geschlossenen Phasenregelschleife beschränkt. Größere Modulationsbandbreiten werden ermöglicht, indem ein digitales Präemphase-Filter vorgesehen wird, dessen Übertragungsfunktion genau mit der inversen Übertragungsfunktion der PLL übereinstimmen muß (siehe Kapitel II.C und insbesondere Figur 3 des Artikels). Um diese Übereinstimmung zu erreichen, wird im genannten Artikel eine automatische Kalibrierungseinheit vorgeschlagen, die den Strom der Ladungspumpe abhängig vom Ausgangssignal des spannungsgesteuerten Oszillators (VCO) und vom Modulationssignal steuert (siehe Kapitel III und insbesondere Figur 4). Nachteilig ist hierbei die Komplexität des Kalibrierungsalgorithmus' und der damit verbundene hohe Realisierungsaufwand der Kalibrierungseinheit (siehe Kapitel IV und insbesondere die Figuren 7, 14, 17, 18 und 20). Weiterhin ist der hohe Verbrauch an Betriebsenergie nachteilig, der mit dem hohen Realisierungsaufwand einhergeht. Außerdem erfordert die Kalibrierungseinheit selbst infolge von zeitverzögernden Einheiten (Phasenakkumulator, Filter, Integrator etc.) eine nachteilige Totzeit bis zum Einsetzen der Kalibrierung.

Aus dem im Tagungsband zur "2003 IEEE International Solid-State Circuits Conference" auf den Seiten 64, 65 und 432 erschienenen Artikel "A 43mW Bluetooth Transceiver with -91dBm Sensitivity" von Christian Cojocaru et al. ist ein weiterer direkt modulierender Frequenzmodulator mit einer geschlossenen Phasenregelschleife bekannt. Hierbei wird ebenfalls der PLL-Synthesizer moduliert, indem der Teilerwert des Frequenzteilers im Rückkopplungszweig in Abhängigkeit vom Modulationssignal variiert wird. Weiterhin wird das Modulationssignal gefiltert und über einen Digital/ Analog-Wandler einem zweiten Steuereingang des Oszillators zugeführt. Nachteilig ist hierbei der insbesondere durch das Filter und die zwei Digital/Analog-Wandler verursachte erhöhte Implementierungsaufwand sowie der hierdurch bedingte erhöhte Energieverbrauch. Außerdem ist die Frequenzänderung des Ausgangssignals pro Zeiteinheit relativ gering.

Vor diesem Hintergrund liegt der Erfindung die Aufgabe zugrunde, einen Frequenzmodulator der genannten Art anzugeben, der einfach zu implementieren und energiesparend zu betreiben ist, schnelle und präzise Frequenzwechsel und höherratige Modulationssignale erlaubt, damit leistungsfähige Sende-/Empfangs-vorrichtungen einfach, kostengünstig und energieeffizient implementiert bzw. betrieben werden können.

Erfindungsgemäß wird diese Aufgabe gelöst durch einen Frequenzmodulator, eine Sende-/Empfangsvorrichtung und eine integrierte Schaltung mit den Merkmalen der Patentansprüche 1, 19 bzw. 20.

Der erfindungsgemäße Frequenzmodulator zum Generieren eines Ausgangssignals mit einer von einem Modulationssignal abhängigen Frequenz, wobei das Modulationssignal $N \geq 2$ unterschiedliche diskrete Modulationswerte annehmen kann und jedem Modulationswert ein vorgegebener Frequenzwert des Ausgangssignals zugeordnet ist, enthält

> a) eine geschlossene Phasenregelschleife mit einem Schleifenfilter zum Bereitstellen einer ersten Steuerspannung, einem spannungsgesteuerten Oszillator zum Generieren des Ausgangssignals und einem schaltbaren Frequenzteiler zum Ableiten eines frequenzgeteilten Signals, und

> b) eine Modulationseinheit, die ausgebildet ist, an einem ersten Ausgang vom Modulationssignal abhängige Werte eines Teilers und an einem zweiten Ausgang eine vom Modulationssignal abhängige zweite Steuerspannung bereitzustellen,

c) wobei der Oszillator einen mit dem Schleifenfilter verbundenen ersten Steuereingang und einen mit dem zweiten Ausgang der Modulationseinheit verbundenen zweiten Steuereingang aufweist und ausgebildet ist, das Ausgangssignal in Abhängigkeit von der ersten Steuerspannung und der zweiten Steuerspannung zu generieren,

d) wobei der Frequenzteiler mit dem ersten Ausgang der Modulationseinheit verbunden und ausgebildet ist, das frequenzgeteilte Signal derart abzuleiten, daß es von den Teilerwerten abhängigen Momentanfrequenzen aufweist, und

e) wobei die Modulationseinheit einen kapazitiven Spannungsteiler mit einem Mittelabgriff aufweist und ausgebildet ist, die zweite Steuerspannung am Mittel-abgriff bereitzustellten.

Die erfindungsgemäße Sende-/Empfangsvorrichtung und die erfindungsgemäße integrierte Schaltung weisen jeweils einen solchen Frequenzmodulator auf.

Das Wesen der Erfindung besteht darin, die Dauer zu verkürzen, in der die zweite Steuerspannung von einem ersten Spannungswert, der einem ersten Modulationswert zugeordnet ist, zu einem zweiten Spannungswert, der einem zweiten Modulationswert zugeordnet ist, übergeht. Erfindungsgemäß wird dies erreicht, indem mittels eines kapazitiven Spannungsteilers ein definierter Strom am Mittelabgriff des Spannungsteilers aufgeprägt bzw. von diesem abgeführt wird. Durch diese einfach zu implementierende und energiesparend zu betreibende Lösung wird die Dauer des Übergangs (Einschwingvorgangs) der zweiten Steuerspannung vom ersten zum zweiten Spannungswert drastisch reduziert, so daß vorteilhaft Frequenzwechsel schneller und präziser ausgeführt und auch höherratige Modulationssignale verarbeitet werden können.

Vorteilhafte Ausgestaltungen und Weiterbildungen der Erfindung sind den abhängigen Ansprüchen sowie der Beschreibung unter Bezugnahme auf die Zeichnung zu entnehmen.

In einer vorteilhaften Ausgestaltung weist die Modulationseinheit einen resistiven Spannungsteiler auf, dessen Mittelabgriff mit dem Mittelabgriff des kapazitiven Spannungsteilers verbunden ist. Vorzugsweise weisen der kapazitive und der resistive Spannungsteiler jeweils einen Hochpunkt auf, die auf demselben Potential liegen. Hierdurch wird vorteilhaft der statische Arbeitspunkt für das durch die zweite Steuerspannung gesteuerte kapazitive Element des spannungsgesteuerten Oszillators eingestellt.

In einer weiteren vorteilhaften Ausgestaltung weist der kapazitive Spannungsteiler ein zwischen dem Mittelabgriff und einem Bezugspunkt angeordnetes erstes kapazitives Element und ein zwischen dem Mittelabgriff und einem Hochpunkt des kapazitiven Spannungsteilers angeordnetes zweites kapazitives Element auf, wobei vorzugsweise parallel zum ersten kapazitiven Element ein erstes resistives Element und parallel zum zweiten kapazitiven Element ein zweites resistives Element geschaltet ist. Ein solcher Frequenzmodulator ist besonders einfach zu implementieren.

In einer vorteilhaften Ausführungsform weist das erste kapazitive und das erste resistive Element und/oder das zweite kapazitive und das zweite resistive Element einen einstellbaren Wert und die Modulationseinheit eine Umsetzeinheit auf, die ausgebildet ist, die einstellbaren Werte in Abhängigkeit vom jeweils aktuellen Wert des Modulationssignals einzustellen. Neben schnellen Frequenz-wechseln kann durch diese Einstellbarkeit der Werte vorteilhaft der Frequenzhub des Modulators eingestellt bzw. kalibriert werden.

In einer bevorzugten Ausführungsform weist die Modulationseinheit eine mit einem Hochpunkt des kapazitiven Spannungsteilers verbundene Umsetzeinheit auf, die ausgebildet ist, jedem Modulationswert einen vorgegebenen Potentialwert zuzuordnen und denjenigen vorgegebenen Potentialwert am Hochpunkt anzulegen, der dem jeweils aktuellen Wert des Modulationssignals zugeordnet ist. Ein solcher Frequenzmodulator ist besonders einfach zu implementieren.

In einer weiteren Ausgestaltung weist der Oszillator ein erstes und ein zweites frequenzbestimmendes kapazitives Element mit einem einstellbaren ersten bzw. zweiten Kapazitätswert auf und ist der Frequenzmodulator ausgebildet, den ersten Kapazitätswert mit Hilfe der ersten Steuerspannung und den zweiten Kapazitätswert mit Hilfe der zweiten Steuerspannung einzustellen. Vorzugsweise ist der Oszillator ausgebildet, die erste und die zweite Steuerspannung mit voneinander verschiedenen Steilheiten umzusetzen. Hierdurch werden die Genauigkeitsanforderungen an die Werte der Bauelemente des kapazitiven Spannungsteilers vorteilhaft reduziert.

Die Erfindung wird nachfolgend anhand der in den schematischen Figuren der Zeichnung angegebenen Ausführungsbeispiele näher erläutert. Hierbei zeigen

Fig. 1 Beispiel eines "Wireless Personal Area Network" (WPAN) nach IEEE 802.15.4 mit erfindungsgemäßen Sende-/ Empfangsvorrichtungen;

Fig. 2 Ausführungsbeispiel eines erfindungsgemäßen Frequenzmodulators;

Fig. 3 erste Ausführungsform einer erfindungsgemäßen Modulationseinheit;

Fig. 4 Zeitverläufe des Modulationssignals, der VCO-Steuerspannungen und der Frequenz des VCO-Ausgangssignals; und

Fig. 5 zweite Ausführungsform einer erfindungsgemäßen Modulationseinheit.

In den Figuren sind gleiche und funktionsgleiche Elemente und Signale - sofern nicht anders angegeben - mit denselben Bezugszeichen versehen.

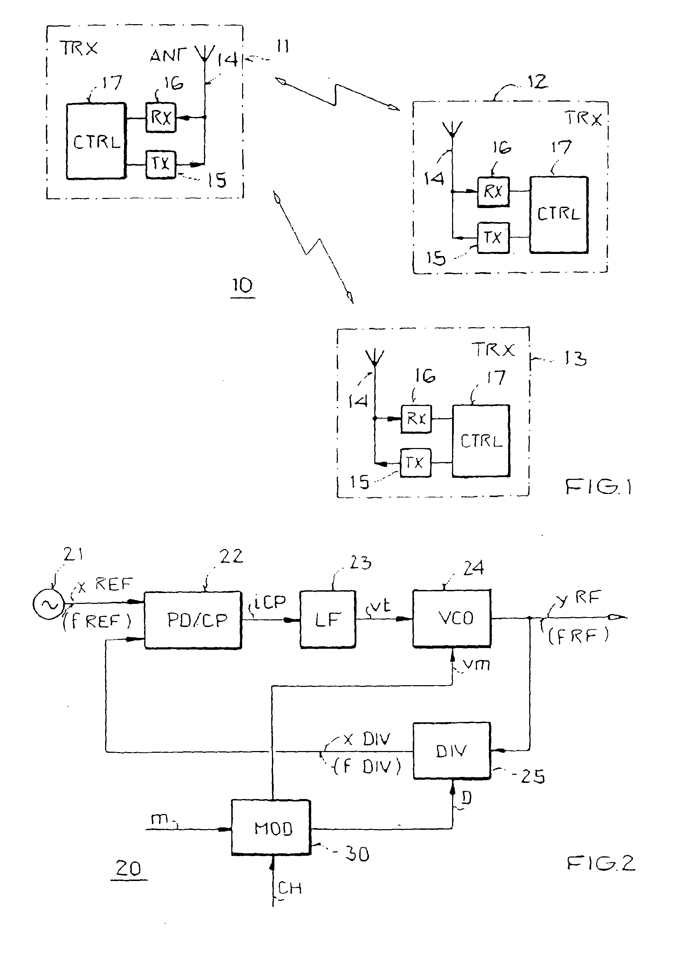

Zur drahtlosen Übertragung von Informationen über relativ kurze Distanzen können sog. "Wireless Personal Area Networks" (WPAN) verwendet werden. **Fig. 1** zeigt ein Beispiel eines WPANs 10 nach dem Standard IEEE 802.15.4. Dieser Standard spezifiziert niederratige WPANs, die mit Rohdatenraten bis max. 250 kbit/s und ortsfesten oder mobilen Geräten für Anwendungen in der industriellen Überwachung und Steuerung, in Sensornetzwerken, in der Automatisierung sowie im Bereich der Computerperipherie und für interaktive Spiele geeignet sind. Neben einer sehr einfachen und kostengünstigen Implementierbarkeit der Geräte ist für derartige Anwendungen ein extrem geringer Energiebedarf der Geräte von entscheidender Bedeutung. So werden mit diesem Standard Batterielaufzeiten von mehreren Monaten bis mehrere Jahre angestrebt.

Das in Figur 1 dargestellte WPAN umfaßt drei Sende-/Empfangsvorrichtungen (transceiver, TRX) 11-13 in Form von ortsfesten oder mobilen Geräten, die mittels Funksignalen drahtlos Informationen austauschen. Bei der Sende-/ Empfangsvor-richtung 11 handelt es sich um ein sog. Vollfunktionsgerät, das die Funktion des WPAN-Koordinators übernimmt, während es sich bei den Sende-/Empfangsvorrichtungen 12, 13 um sog. Teilfunktionsgeräte handelt, die dem Vollfunktionsgerät 11 zugeordnet sind und nur mit diesem Daten austauschen können. Neben der in Fig. 1 dargestellten sternförmigen Netzwerktopologie, bei der die bidirektionale Datenübertragung nur zwischen jeweils einem der Teilfunktionsgeräte 12, 13 und dem Vollfunktionsgerät 11, nicht jedoch zwischen den Teilfunktionsgeräten 12, 13 erfolgen kann, sieht der Standard auch sog. "Peer-to-Peer"-Topologien vor, bei denen sämtliche Vollfunktionsgeräte mit jeweils allen anderen Vollfunktionsgeräten kommunizieren können.

Die Sende-/Empfangsvorrichtungen 11-13 umfassen jeweils eine Antenne 14, eine mit der Antenne verbundene Sendeeinheit (transmitter, TX) 15, eine mit der Antenne verbundene Empfangseinheit (receiver, RX) 16 und eine mit der Sende- und der Empfangseinheit verbundene Kontrolleinheit (control unit, CTRL) 17 zur Steuerung derselben. Weiterhin beinhalten die Sende-/Empfangsvorrichtungen 11-13 jeweils eine in Fig. 1 nicht dargestellte Energieversorgungseinheit in Form einer Batterie etc. zur Energieversorgung der Einheiten 15-17, sowie eventuell weitere Komponenten (Sensoren, Schnittstellen, Aktoren etc.).

Im folgenden wird davon ausgegangen, daß die Datenübertragung im lizenzfreien ISM-Band (industrial, scientific, medical) bei 2,4 GHz erfolgt.

In diesem Frequenzband sieht der IEEE-Standard 802.15.4 insgesamt 16 Kanäle im Abstand von jeweils 5 MHz vor, wobei die Mittenfrequenzen fCH der Kanäle bei 2405, 2410, ..., 2480 MHz liegen. Für Rohdatenraten von fB=250 kbit/s ist in diesen Kanälen eine Bandspreizung (Spreading) mit einer Chiprate von fC=2 Mchip/s sowie eine Offset-QPSK-Modulation (quarternary phase shift keying) mit Halbsinus-Impulsfor-mung spezifiziert.

Die Sendeeinheit 15 jeder Sende-/Empfangsvorrichtung wandelt den jeweils zu übertragenden Datenstrom in ein über ihre Antenne 14 abzustrahlendes Funksignal um, indem der zu sendende Datenstrom gemäß IEEE 802.15.4 zunächst in vier Bit breite Symbole und diese in aufeinanderfolgende PN-Sequenzen (pseudo noise) aus jeweils 32 Chips umgesetzt werden. Die Chips der aufeinanderfolgenden PN-Sequenzen werden anschließend Offset-QPSK-moduliert, spektral in einen der 16 Kanäle im ISM-Frequenzband verschoben und schließlich für die Übertragung verstärkt. Da eine Offset-QPSK-Modulation mit Halbsinus-Impulsfor-mung einer MSK-Modulation (minimum shift keying), d.h. einer FSK-Modulation (frequency shift keying) mit Modulationsindex 1/2 bzw. Frequenzhub $\Delta F=fC/4= 0,5$ MHz entspricht, kann der Modulator in der Sendeeinheit 15 als Frequenzmodulator ausgeführt werden.

Die Empfangseinheit 16 jeder Sende-/Empfangsvorrichtung wandelt ein von ihrer Antenne 14 empfangenes und von der Sendeeinheit einer anderen Sende-/ Empfangsvorrichtung nach IEEE 802.15.4 erzeugtes Funksignal möglichst fehlerfrei in die gesendeten Daten um, indem das empfangene Funksignal verstärkt, spektral verschoben und demoduliert wird und schließlich die Daten detektiert (entschieden) werden.

Die Sendeeinheit 15 und die Empfangseinheit 16 einer Sende-/Empfangs-vorrichtung sind hierbei Teil einer (in Fig. 1 nicht dargestellten) integrierten Schaltung, z.B. eines ASIC (application specific integrated circuit) oder eines ASSP (application specific standard product), während die Kontrolleinheit 17 durch einen (ebenfalls nicht dargestellten) Mikrocontroller realisiert ist. Vorteilhaft weist die Sende-/Empfangsvorrichtung nur eine z.B. als ASIC ausgeführte integrierte Schaltung auf, die die Funktionen der Sendeeinheit 15, der Empfangseinheit 16 und der Kontrolleinheit 17 wahrnimmt.

**Figur 2** zeigt ein Blockschaltbild eines erfindungsgemäßen Frequenzmodulators. Der Frequenzmodulator 20 generiert ein ggf. verstärktes Ausgangssignal yRF mit einer von einem Modulationssignal m und einem gewünschten Kanal im ISM-Band abhängigen (Momentan)Frequenz fRF, wobei das Modulationssignal m im allgemeinen N, mindestens jedoch zwei unterschiedliche diskrete Modulationswerte m0, m1, ... annehmen kann. Jedem Modulationswert ist hierbei ein vorgegebener (Ziel)Frequenzwert f0, f1, ... des Ausgangssignals yRF zugeordnet. Das Ausgangssignal yRF wird schließlich durch einen Leistungsverstärker verstärkt und über die Antenne abgestrahlt (nicht in Figur 2 dargestellt).

Im Falle eines Frequenzmodulators für eine Sendeeinheit 15 aus Fig. 1 besteht das Modulationssignal m gemäß IEEE 802.15.4 aus im Chiptakt von fC=2 Mchip/s vorliegenden vorcodierten Chips der aufeinanderfolgenden PN-Sequenzen, wobei die vorcodierten Chips jeweils einen binären Wert von (logisch) null oder eins annehmen können. Das Modulationssignal m weist in diesem Falle also zwei unterschiedliche Modulationswerte m0=0 und m1=1 auf. Bei einem Modulationswert von null (m0) soll die (Momentan)Frequenz fRF des VCO-Ausgangssignals yRF beispielsweise den Frequenzwert f0 annehmen, während ein Modulationswert von eins (m1) auf den Frequenzwert f1 führen soll. Hierbei gilt

$$f0 = fCH - \Delta F \qquad und \qquad f1 = fCH + \Delta F , \qquad (1)$$

wobei fCH die Mittenfrequenz des gewünschten Kanals im ISM-Band und $\Delta F$ den MSK-Frequenzhub $\Delta F = fC/4 = 0{,}5$ MHz bezeichnen.

Gemäß Fig. 2 weist der Frequenzmodulator 20 einen Referenzoszillator 21, eine Phasenregelschleife (PLL) 22-25 und eine Modulationseinheit (MOD) 30 auf.

Die Phasenregelschleife 22-25 umfaßt einen Phasen(differenz)detektor/Ladungs-pumpe (phase detector/charge pump, PD/CP) 22, ein Schleifenfilter (loop filter, LF) 23, einen spannungsgesteuerten Oszillator (voltage controlled oscillator, VCO) 24 zum Generieren des Ausgangssignals yRF und einen schaltbaren Frequenzteiler (DIV) 25 zum Ableiten eines frequenzgeteilten Signals xDIV. Die Phasenregelschleife 22-25 ist geschlossen ("closed loop"), d.h. sie wird im Gegensatz zu sog. "open loop" Modulatoren auch in denjenigen Zeitabschnitten nicht geöffnet, in denen aktiv moduliert wird.

Der Modulationseinheit (MOD) 30 wird das Modulationssignal m und eine der Mittenfrequenz fCH des gewünschten Kanals zugeordnete Größe wie z.B. ein Index CH des gewünschten Kanals zugeführt.

Nachfolgend werden die Funktionsblöcke 21-25 und 30 eingehender erläutert.

Der Referenzoszillator 21 generiert ein ggf. verstärktes Referenzsignal xREF mit einer Referenzfrequenz fREF von beispielsweise 16 MHz und ist z.B. als Quarzoszillator oder als spannungsgesteuerter Quarzoszillator ausgebildet.

Die PD/CP-Einheit 22 weist zwei mit dem Referenzoszillator 21 bzw. dem Frequenzteiler 25 verbundene Eingänge auf. Die PD/CP-Einheit bestimmt die Phasenabweichung (Phasendifferenz) zwischen dem Referenzsignal xREF des Referenzoszillators 21 und dem frequenzgeteilten Signal xDIV des Frequenzteilers 25 und stellt an ihrem Ausgang in Abhängigkeit von der Phasenabweichung einen definierten Strom iCP bereit. Anstelle des Phasendetektors kann auch ein Phasenfrequenzdetektor vorgesehen sein.

Das Schleifenfilter (LF) 23 weist einen mit der PD/CP-Einheit 22 verbundenen Eingang und einen mit dem VCO 24 verbundenen Ausgang auf. In Abhängigkeit von dem am Eingang anliegenden Strom iCP generiert das Schleifenfilter 23 eine erste Steuerspannung vt und stellt diese an seinem Ausgang bereit.

Die Modulationseinheit (MOD) 30 ermittelt in Abhängigkeit vom Modulationssignal m und dem Index CH Werte eines Teilers D und stellt diese an einem ersten Ausgang bereit. Weiterhin generiert die Modulationseinheit 30 eine vom Modulationssignal m abhängige zweite Steuerspannung vm und stellt diese an einem zweiten Ausgang bereit.

Der spannungsgesteuerte Oszillator (VCO) 24 weist einen mit dem Schleifenfilter 23 verbundenen ersten Steuereingang, einen mit dem zweiten Ausgang der Modulationseinheit 30 verbundenen zweiten Steuereingang sowie einen mit dem Frequenzteiler 25 verbundenen Ausgang auf. In Abhängigkeit von der am ersten Steuereingang anliegenden ersten Steuerspannung vt und der am zweiten Steuereingang anliegenden zweiten Steuerspannung vm generiert der VCO 24 das ggf. verstärkte Ausgangssignal yRF.

Der schaltbare Frequenzteiler (DIV) 25 weist einen mit dem VCO 24 verbundenen Signaleingang sowie einen mit dem ersten Ausgang der Modulationseinheit 30 verbundenen Steuereingang auf. Der Frequenzteiler 25 leitet aus dem VCO-Ausgangssignal yRF ein frequenzgeteiltes Signal xDIV ab, dessen Momentanfrequenz fDIV vom jeweils aktuellen Wert des an seinem Steuereingang anliegenden Teilers D abhängt und stellt das frequenzgeteilte Signal xDIV an seinem Ausgang bereit. Bei der Frequenzteilung wird die Frequenz fRF des VCO-Ausgangs-signals yRF geteilt durch einen vom Index CH des gewünschten Kanals und vom aktuellen Wert des Modulationssignals m abhängigen Teiler D, so daß für die Frequenz fDIV des frequenzgeteiltes Signals xDIV der folgende Zusammenhang gilt:

$$fDIV = fRF / D. \hspace{4cm} (2)$$

Aus den minimal bzw. maximal möglichen Frequenzwerten

$$f0min = fCHmin - \Delta F = (2405 - 0,5)\,\text{MHz} = 2404,5\,\text{MHz} \quad \text{bzw.} (3a)$$

$$f1max = fCHmax + \Delta F = (2480 + 0,5)\,\text{MHz} = 2480,5\,\text{MHz} \hspace{1cm} (3b)$$

für die Frequenz fRF und der o.g. Referenzfrequenz von z.B. fREF=16 MHz ergeben sich die kleinsten und größten Teilerwerte zu 150,28125 bzw. 155,03125.

Um derartige nichtganzzahlige Teilerwerte zu realisieren, ist der Frequenzteiler 25 schaltbar ausgeführt, wobei er jeweils zeitweise Frequenzteilungen mit unterschiedlichen ganzzahligen Teilerwerten D derart vornimmt, daß sich über ein gewisses Zeitintervall betrachtet "im Mittel" der erforderliche nichtganzzahlige Teilerwert ergibt. Phasenregelschleifen mit einem solchen schaltbaren Frequenzteiler werden als "fractional-N PLL" bezeichnet.

Vorzugsweise ist der Frequenzteiler 25 als sog. multi modulus divider (MMD), d.h. als digitaler, im Zählbereich programmierbarer Zähler, realisiert. Vorteilhaft besteht der MMD aus zwei Frequenzteilern, wobei der erste auch als Prescaler bezeichnet wird und ausgebildet ist, Frequenzteilungen durch K oder K+1 vorzunehmen und der zweite mit einem üblicherweise festen Teilerverhältnis arbeitet und den Moduluseingang des Prescalers in Abhängigkeit des am Steuereingang anliegenden Teilers D steuert.

Zur Kompensation des durch die Variation der Teilerwerte verursachten Phasenfehlers zwischen dem frequenzgeteilten Signal xDIV und dem Referenzsignal xREF kann die Phasenregelschleife zwischen dem Frequenzteiler 25 und der PD/CP-Einheit 22 vorteilhaft eine schaltbare Verzögerungseinheit aufweisen.

Anstelle einer fractional-N-Phasenregelschleife kann bei entsprechenden Verhältnissen der Zielfrequenzwerte und der Referenzfrequenz auch eine sog. "integer-N" PLL vorgesehen sein. Die Erfindung ist insofern nicht auf eine bestimmte Architektur der PLL beschränkt.

**Figur 3** zeigt einen Ausschnitt eines Schaltbildes eines erfindungsgemäßen Frequenzmodulators. Insbesondere zeigt Fig. 3 eine bevorzugte erste Ausführungsform der Modulationseinheit 30 sowie schematisch einen exemplarischen VCO 24.

Der VCO 24 weist einen Schwingkreis zur Erzeugung einer Schwingung sowie einen Verstärker zur Entdämpfung dieser Schwingung auf. Er umfaßt weiterhin einen ersten Steuereingang zum Zuführen der vom Schleifenfilter 23 bereitgestellten ersten Steuerspannung vt, einen zweiten Steuereingang zum Zuführen der von der Modulationseinheit 30 generierten zweiten Steuerspannung vm und einen differentiellen Ausgang zum Bereitstellen des Ausgangssignals yRF.

Der Verstärker umfaßt exemplarisch zwei kreuzgekoppelte Feldeffekttransistoren (FET) T1, T2.

Der Schwingkreis beinhaltet zwei Induktivitäten L1, L2 und zwei parallel geschaltete kapazitive Elemente Ct, Cm, deren Bauteilwerte zusammen die Frequenz der Schwingung bestimmen. Zur Einstellung der Frequenz fRF des Ausgangssignals yRF auf den vorgegebenen (Ziel)Frequenzwert weisen die Elemente Ct, Cm jeweils einen einstellbaren Kapazitätswert auf, wobei der Kapazitätswert des ersten kapazitiven Elementes Ct durch die erste Steuerspannung vt und der Kapazitätswert des zweiten kapazitiven Elementes Cm mit Hilfe der zweiten Steuerspannung vm eingestellt wird. Die kapazitiven Elemente Ct, Cm sind vorzugsweise als Varaktoren, Kapazitätsdioden oder dergleichen ausgestaltet.

Vorzugsweise ist der VCO 24 ausgestaltet, die erste und die zweite Steuerspannung vt, vm mit voneinander verschiedenen Steilheiten K1 bzw. K2 in eine Frequenz fRF des Ausgangssignals yRF umzusetzen, wobei die Steilheit K2 der Umsetzung der zweiten Steuerspannung vm üblicherweise kleiner ist als die Steilheit K1 der Umsetzung der ersten Steuerspannung vt.

Bauelemente zur Einstellung von Arbeitspunkten, Koppelkondensatoren etc. sind im VCO 24 zur Vereinfachung der exemplarischen Darstellung nicht gezeigt.

Die Modulationseinheit 30 weist eine Umsetzeinheit (MAP) 31, einen Spannungsteiler 32 sowie eine Teilerbestimmungseinheit 36 auf.

Der Spannungsteiler 32 weist einen Hochpunkt 32-1, einen Mittelabgriff 32-2 und einen Bezugspunkt 32-3 auf, wobei der Mittelabgriff 32-2 zum Bereitstellen der zweiten Steuerspannung vm mit dem zweiten Ausgang der Modulationseinheit 30 verbunden ist, während der Hochpunkt 32-1 mit dem Ausgang der Umsetzeinheit 31 verbunden ist und der Bezugspunkt auf einem Bezugspotential wie z.B. Masse liegt.

Zwischen dem Mittelabgriff 32-2 und dem Bezugspunkt 32-3 des Spannungsteilers ist eine Parallelschaltung aus einem ersten kapazitiven Element C1 und einem ersten resistiven Element R1 angeordnet, während zwischen dem Mittelabgriff 32-2 und dem Hochpunkt 32-1 eine Parallelschaltung aus einem zweiten kapazitiven Element C2 und einem zweiten resistiven Element R2 angeordnet ist.

Die kapazitiven Elemente C1, C2 bilden einen kapazitiven Spannungsteiler, während die resistiven Elemente R1, R2 einen hierzu parallel geschalteten resistiven Spannungsteiler ergeben, wobei die kapazitiven und resistiven Spannungsteiler einen gemeinsamen Mittelabgriff 32-2, einen gemeinsamen Hochpunkt 32-1 und einen gemeinsamen Bezugspunkt 32-3 aufweisen.

Beim ersten kapazitiven Element C1 handelt es sich um eine rein parasitäre oder um eine teilweise parasitäre Kapazität. Das zweite kapazitive Element C2 (und ggf. der nichtparasitäre Anteil des ersten kapazitiven Elements C1) ist vorzugsweise als MIM-Kondensator (Metal-Insulator-Metal) ausgeführt.

Vorzugsweise werden die Bauelemente des Spannungsteilers so gewählt, daß die Beziehung R1/C1' = R2/C2 gilt. Hierbei umfaßt C1' alle parasitären und effektiven Kapazitäten am Mittelabgriff 32-2, so daß auch die frequenzbestimmende Kapazität Cm des VCO 24 berücksichtigt wird.

Zur Versorgung der Kapazität Cm mit einer Biasspannung ist zwischen dem Mittelabgriff 32-2 und einem Anschluß der Versorgungsspannung VDD vorzugsweise ein weiteres, nicht in Fig. 3 dargestelltes drittes resistives Element R3 vorgesehen, das mit dem ersten resistiven Element R1 einen Spannungsteiler bildet.

Das erste resistive Element R1, das erste kapazitive Element C1 und ggf. das dritte resistive Element R3 kann vorteilhaft jeweils einen einstellbaren Wert aufweisen. Auf diese Weise kann vorteilhaft der Modulationsindex bzw. Frequenzhub $\Delta F$ eingestellt bzw. kalibriert werden.

Die Umsetzeinheit (MAP) 31, der eingangsseitig das Modulationssignal m zugeführt wird, ist ausgangsseitig mit dem Hochpunkt 32-1 des Spannungsteilers 32 verbunden. Die Umsetzeinheit 31 setzt das Modulationssignal m in ein Steuersignal vx um, indem jedem unterschiedlichen Modulationswert (m0, m1, ...) ein vorgegebener Potentialwert vx0, vx1, ... zugeordnet wird und derjenige vorgegebene Potentialwert am Hochpunkt 32-1 des Spannungsteilers 32 angelegt wird, der dem jeweils aktuellen Wert des Modulationssignals m zugeordnet ist.

Im hier betrachteten Fall eines zweistufigen (N=2) Modulationssignals m weist die Umsetzeinheit 31 vorzugsweise eine Schalteinheit 31 a auf, die ausgestaltet ist, den Ausgang der Umsetzeinheit in Abhängigkeit vom jeweils aktuellen Wert des Modulationssignals m entweder mit der Versorgungsspannung VDD oder aber mit einem Bezugspotential (z.B. Masse) zu verbinden (jeweils ggf. über einen Widerstand 31 b bzw. 31 c). Beispielsweise wird der Ausgang der Umsetzeinheit 31 mit der Versorgungsspannung VDD verbunden, falls das Modulationssignal aktuell den Wert m0 annimmt, und mit dem Bezugspotential, falls es aktuell den Wert m1 annimmt.

Bei höherstufigen Modulationssignalen m mit N>2 unterschiedlichen Modulationswerten werden vorzugsweise N äquidistante Potentialwerte durch die Umsetzeinheit 31 bereitgestellt. Im Falle von N=4 können beispielsweise die vier Potentialwerte VDD, (2/3)*VDD, VDD/3 und 0V (Masse) bereitgestellt werden, falls das Modulationssignal aktuell den Wert m0, m1, m2 bzw. m3 annimmt.

Die in Fig. 3 dargestellte exemplarische Teilerbestimmungseinheit 36 weist eine F/I-Einheit 37, einen Sigma-Delta-Modulator 38 sowie eine Addiereinheit 39 auf. Der F/I-Einheit 37 werden an ihren beiden Eingängen das Modulationssignal m und der Index CH des gewünschten Kanals zugeführt, während der Ausgang der Addiereinheit 39 über den ersten Ausgang der Modulationseinheit 30 mit dem Steuereingang des Frequenzteilers 25 verbunden ist. Eingangsseitig ist die Addiereinheit 39 mit dem ersten Ausgang der F/I-Einheit 37 sowie dem Ausgang des Sigma-Delta-Modulators 38 verbunden, der seinerseits eingangsseitig mit dem zweiten Ausgang der F/I-Einheit 37 verbunden ist.

Die F/I-Einheit 37 bestimmt aus dem Index CH des gewünschten Kanals und dem aktuellen Wert des Modulationssignals m einen ersten Wert INT und einen zweiten Wert FRAC. Die beiden ganzzahligen Werte INT und FRAC geben hierbei in Vielfachen von fREF=16 MHz bzw. $\Delta F$=0,5 MHz=fREF/32 an, welcher Frequenz-offset zu einer Grundfrequenz von 2304 MHz addiert werden muß, um die in Anbetracht des CH-Wertes und des aktuellen Modulationswertes gewünschte Zielfrequenz f0 oder f1 zu erreichen. Die Werte INT und FRAC werden also so gewählt, daß der Wert

$$2304 \text{ MHz} + INT * 16 \text{ MHz} + FRAC * 0{,}5 \text{ MHz} \qquad (4)$$

die gewünschte Zielfrequenz f0 (für m0) bzw. f1 (für m1) ergibt. Je nach Kanalindex CH und Modulationswert können die Größen INT und FRAC Werte im Bereich von 6 bis 11 bzw. von 0 bis 31 annehmen können. Die F/I-Einheit 37 ist vorzugsweise als Lookup-Table realisiert.

Der Sigma-Delta-Modulator 38, dem der Wert FRAC zugeführt wird, ermittelt im einfachsten Falle eines Sigma-Delta-Modulators erster Ordnung eine höherratige (z.B. 8*fC) Folge von Null- und Einswerten, deren relative Häufigkeit den FRAC-Wert widerspiegelt. So führt beispielsweise der Wert FRAC=16, der für einen Frequenzoffset von 16/32*fREF = 1/2*fREF steht, auf eine Folge aus Nullen und Einsen, deren Anzahlen übereinstimmen. Anstelle von zweistufigen Folgen mit Null- und Einswerten können mit Hilfe eines Sigma-Delta-Modulators höherer Ordnung auch höherstufige Folgen z.B. mit ganzzahligen Werten zwischen -1 und 2 erzeugt werden.

In der Addiereinheit 39 werden die vom Sigma-Delta-Modulator 38 erzeugten Werte schließlich zum INT-Wert addiert und die Summenwerte dem Frequenzteiler 25 zugeführt. Mit Hilfe dieser Summenwerte realisiert der Frequenzteiler 25 die Frequenzteilung mit dem erforderlichen Teiler D.

Die in Fig. 3 dargestellte exemplarische Teilerbestimmungseinheit 36 kann alternativ auch auf andere Weise, insbesondere auch ohne Sigma-Delta-Modulator, sondern mit einem Akkumulator implementiert sein. Weiterhin können auch andere Realisierungen des VCO 24 vorgesehen sein.

Der vorstehend anhand der Fig. 2 und 3 erläuterte erfindungsgemäße Frequenzmodulator ist besonders einfach zu realisieren und energiesparend zu betreiben. Er ist darüber hinaus robust gegenüber Toleranzen innerhalb der Phasenregelschleife, die z.B. durch Schwankungen der Temperatur oder der Versorgungsspannung oder durch Prozeßvariationen verursacht werden können. Diese Vorteile gelten sowohl für den Fall eines zweistufigen Modulationssignals m als auch für den Fall höherstufiger Modulationssignale (N>2).

**Figur 4** zeigt schematisch exemplarische Zeitverläufe des Modulationssignals m, der VCO-Steuerspannungen vm, vt und der Frequenz fRF des Ausgangssignals yRF in einem Frequenzmodulator ohne (Fig. 4a-d) bzw. mit (Fig. 4e-h) erfindungsgemäßer Modulationseinheit.

Wie aus den Figuren 4a und 4e zu erkennen ist, nimmt das zweistufige Modulationssignal m im dargestellten Fall bis zum Zeitpunkt t=T1 den Wert m0=0, zwischen den Zeitpunkten T1 und T2 den Wert m1=1 und anschließend wiederum den Wert m1=1 an. Dem Modulationswert m0 ist hierbei exemplarisch die (Ziel)Frequenz f0 des VCO-Ausgangssignals yRF zugeordnet, während der Modulationswert m1 auf die Frequenz f1 führen soll.

Für einen Frequenzmodulator gemäß Fig. 2 mit einer erfindungsgemäßen Modulationseinheit gemäß Fig. 3 zeigen die Figuren 4f-h den zeitlichen Verlauf der VCO-Steuerspannungen vm und vt sowie den zeitlichen Verlauf der Momentanfrequenz fRF des resultierenden VCO-Ausgangssignals yRF. Lediglich zur Veranschaulichung der Wirkungsweise der Erfindung zeigen die Figuren 4b-d die Verläufe dieser Größen für einen hypothetischen Frequenzmodulator gemäß Fig. 2 mit einer Modulationseinheit, die *keinen* kapazitiven Spannungsteiler aufweist.

Wie aus den Figuren 4b, 4f und 4c, 4g zu entnehmen ist, nehmen die VCO-Steuerspannungen vm bzw. vt anfangs (t<T1) konstant einen Spannungswert vm0 bzw. vt0 an. Diese Spannungswerte vm0, vt0 führen gemäß Fig. 4d, 4h am VCO-Ausgang auf ein Ausgangssignal yRF mit der Frequenz f0, die gemäß der oben eingeführten Annahme dem Modulationswert m0=0 zugeordnet ist. Die Phasenregelschleife ist in diesem Zustand eingeschwungen. In der erfindungsgemäßen Modulationseinheit 30 aus Fig. 3 befindet sich das Schaltelement 31a der Umsetzeinheit 31 anfangs (t<T1) in der oberen Stellung, so daß am Hochpunkt 32-1 des Spannungsteilers 32 das Potential der Betriebsspannung (vx=vx0=VDD) anliegt und sich der Kondensator C2 im aufgeladenen Zustand befindet.

Im Zeitpunkt t=T1, in dem das Modulationssignal m gemäß Fig. 4a vom Modulationswert null auf den Wert eins wechselt, beginnt gemäß Fig. 4b ein Einschwingvorgang der VCO-Steuerspannung vm vom Wert vm0 auf den Spannungswert vm1. Die Zeitkonstante dieses Einschwingvorgangs hängt insbesondere von mit dem zweiten Steuereingang des VCO verbundenen Widerständen sowie von parasitären Kapazitäten an diesem Steuereingang ab. Wie in Fig. 4b zu erkennen ist, nimmt dieser Einschwingvorgang eine Zeitspanne in Anspruch, deren Dauer eine Chipperiode TC=500ns deutlich übersteigt, so daß der Spannungswert vm1 im Zeitpunkt t=T1+TC=T2 nicht erreicht wird.

Infolge des sich zum Zeitpunkt t=T1 ändernden Wertes des Modulationssignals m ergeben sich veränderte Teilerwerte D für die Frequenzteilung durch den schaltbaren Frequenzteiler 25 aus Fig. 2. Jede Änderung des Teilerwertes führt zu einer nichtverschwindenen Phasendifferenz zwischen dem resultierenden, geändert frequenzgeteilten Signal xDIV und dem Referenzsignal xREF, die anschließend durch die Phasenregelschleife ausgeregelt wird. Hieraus resultiert ein in Fig. 4c dargestellter Verlauf der vom Schleifenfilter bereitgestellten Steuerspannung vt. Zunächst fällt die Steuerspannung vt ab, um die zunächst große Abweichung der Steuerspannung vm vom erforderlichen Spannungswert vm1 (siehe Fig. 4b) auszugleichen. Mit abnehmender Abweichung zwischen vm und vm1 erreicht die Steuerspannung vt einen Minimalwert und steigt anschließend, bis sie wieder ihren ursprünglichen Wert vt0 erreicht, wenn der Einschwingvorgang der Steuerspannung vm abgeschlossen ist.

Aus Fig. 4d ist zu erkennen, daß die Momentanfrequenz fRF des VCO-Aus-gangssignals yRF ein Einschwingverhalten zeigt, das in seiner zeitlichen Dauer demjenigen der Steuerspannung vm ähnelt. Die Frequenz fRF steigt ab dem Zeitpunkt t=T1 zwar langsam an, erreicht den Zielwert f1 jedoch erst deutlich nach dem Zeitpunkt t=T2. Aufgrund dieses langsamen Frequenzwechsels liegt die Momentanfrequenz fRF zum Zeitpunkt t=T2 zwischen f0 und f1.

Simulationen der Anmelderin haben ergeben, daß die hier beschriebenen Einschwingvorgänge unter realistischen Annahmen deutlich länger als eine Chipperiode TC andauern (typisch: 4*TC...10*TC = 2...5μs), so daß am Ende der jeweiligen Chipperiode die Frequenz fRF nicht den erforderlichen Wert von f0 bzw. f1 erreicht. Die Dauer der Einschwingvorgänge ist hierbei im wesentlichen abhängig von der Grenzfrequenz der geschlossenen Phasenregelschleife, die ihrerseits im wesentlichen abhängt von der Steilheit der Ausgangsfrequenz-/Steuer-spannungs-Kennlinien des VCO, der Übertragungsfunktion des Schleifenfilters, dem von der Ladungspumpe bereitgestellten definierten Strom, dem Teilerwert der Frequenzteilung und dem Wert der Referenzfrequenz. Dieser Sachverhalt beschränkt de facto die Rate des Modulationssignals m auf einen Wert, der deutlich unterhalb der Grenzfrequenz der Phasenregelschleife liegt, so daß ein Frequenzmodulator ohne erfindungsgemäße Modulationseinheit im hier betrachteten Anwendungsfall nicht eingesetzt werden kann.

Mit Hilfe des kapazitiven Spannungsteilers C1, C2 wird dem Mittelabgriff 32-2 in Fig. 3 ein definierter Strom entzogen bzw. aufgeprägt (zugeführt), wobei der Strom so dimensioniert ist, daß die oben beschriebenen Einschwingvorgänge deutlich verkürzt werden. Der definierte Strom fließt erfindungsgemäß über das zweite kapazitive Element C2 dem Mittelabgriff 32-2 zu (in der oberen Stellung des Schaltelements 31a aus Fig. 3) bzw. vom Mittelabgriff 32-2 über das zweite kapazitive Element C2 ab (in der unteren Stellung des Schaltelements 31 a). Hierdurch verkürzt sich der Einschwingvorgang der Steuerspannung vm deutlich, wie aus Fig. 4f zu erkennen ist, wo die Steuerspannung vm in einer sehr kurzen Zeitspanne nach dem Zeitpunkt t=T1, in dem das Schaltelement 31 a von der oberen in die untere Stellung wechselt, auf den Spannungswert vm1 1 abfällt.

Da sowohl die Umsetzeinheit 31 als auch die Teilerbestimmungseinheit 36 momentan durch den jeweils aktuellen Wert des Modulationssignals m gesteuert werden, erfolgt das Einschwingen der Steuerspannung vm praktisch unmittelbar, d.h. im wesentlichen zeitgleich mit der Änderung des Teilerwertes infolge des jeweils "neuen" (aktuellen) Modulationswertes. Daher entsteht praktisch keine von der Phasenregelschleife auszuregelnde Phasendifferenz. Aus diesem Grunde weicht die Steuerspannung vt allenfalls während des kurzen Einschwingvorgangs von vm leicht vom Spannungswert vt0 ab, wie aus Fig. 4g zu erkennen ist.

Die Frequenz fRF zeigt ebenfalls ein sehr schnelles Einschwingverhalten, wie aus Fig. 4h zu erkennen ist. Im wesentlichen zeitgleich mit der Änderung des Teilerwertes bzw. dem Einschwingen von vm steigt die Momentanfrequenz fRF nach dem Zeitpunkt t=T1 innerhalb einer sehr kurzen Zeitspanne TE von ca. TC/50=10ns vom Frequenzwert f0 auf den Zielfrequenzwert f1 an. Derart schnelle Frequenzwechsel sind insbesondere bei ungefilterten Modulationsformen wie der hier betrachteten MSK-Modulation erforderlich und verbessern die Signalqualität (Signal/Rausch-Verhältnis) des Sendesignals und erhöhen damit die Leistungsfähigkeit der empfängerseitigen Datendetektion (Fehlerwahrscheinlichkeit) bzw. die Reichweite.

Aus der obigen Beschreibung wird deutlich, daß die Werte der kapazitiven Elemente C1, C2 des kapazitiven Spannungsteilers und die Potentialwerte vx0, vx1 am Hochpunkt 32-1 des kapazitiven Spannungsteilers so gewählt werden, daß sich die Steuerspannung vm für jeden Modulationswert (m0, m1) in einer Zeitspanne TE, die wesentlich kürzer als die Zeitdauer TC des Modulationswertes ist, auf denjenigen Spannungswert (vm0, vm1) einstellt, der auf denjenigen vorgegebenen Frequenzwert (f0, f1) des Ausgangssignals yRF führt, der dem Modulationswert zugeordnet ist.

Die Dauer der Zeitspanne TE, d.h. die verbleibende Einschwingzeit, hängt hierbei unter anderem von Prozeßtoleranzen der Werte der einzelnen Bauelemente bei der Herstellung, von Schwankungen der Werte infolge von Temperatur- und/oder Alterungseinflüssen sowie von Variationen der Betriebsspannung ab.

Im Falle höherstufiger Modulationssignale mit N>2 unterschiedlichen Modulationswerten werden die Werte der kapazitiven Elemente C1, C2 und die N Potentialwerte vx0, vx1, ... am Hochpunkt 32-1 so gewählt, daß sich die Steuerspannung vm für jeden der N Modulationswerte (m0, m1, ...) in einer Zeitspanne TE, die kürzer als die Zeitdauer TC des Modulationswertes ist, auf denjenigen der N Spannungswerte vm0, vm1, ... einstellt, der auf denjenigen der N vorgegebenen Frequenzwerte f0, f1, ... führt, der dem Modulationswert zugeordnet ist.

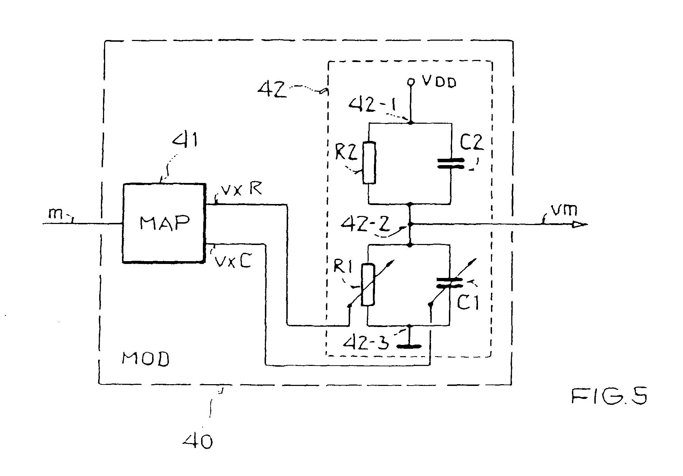

**Figur 5** zeigt eine zweite Ausführungsform der Modulationseinheit. Analog zur oben mit Bezug auf Fig. 3 näher erläuterten ersten Ausführungsform umfaßt die Modulationseinheit, die hier mit dem Bezugszeichen 40 bezeichnet ist, wiederum eine Umsetzeinheit (41), einen Spannungsteiler (42) sowie eine nicht dargestellte Teilerbestimmungseinheit. Der Spannungsteiler 42 weist erste und zweite kapazitive und resistive Elemente R1, R2, C1, C2 auf, die in Übereinstimmung mit Fig. 3 und der vorstehenden Beschreibung verschaltet sind.

Im Gegensatz zur ersten Ausführungsform liegt der Hochpunkt 42-1 des Spannungsteilers 42 hier auf einem festen Potential, z.B. dem Potential der Versorgungsspannung VDD. Weiterhin weisen das erste kapazitive Element C1 einen einstellbaren Kapazitätswert und das erste resistive Element R1 einen einstellbaren Widerstandswert auf. Die zur Einstellung dieser Werte erforderlichen Potentialwerte werden von der Umsetzeinheit 41 in Abhängigkeit vom Modulationssignal m generiert. Hierbei wird jedem unterschiedlichen Modulationswert (m0, m1) ein vorbestimmter Potentialwert vxC0 bzw. vxC1 für das erste kapazitive Element C1 und ein vorbestimmter Potentialwert vxR0 bzw. vxR1 für das erste resistive Element R1 zugeordnet und an den Steuereingang des jeweiligen Elements angelegt.

Das kapazitive Element C1 weist vorzugsweise geschaltete MIM-Kapazitäten auf bzw. ist als CDAC ausgebildet (capacitive digital-toanalog converter), während das resistive Element R1 vorzugsweise geschaltete Widerstände umfaßt.

In einer dritten Ausführungsform der Modulationseinheit weisen nur die zweiten kapazitiven und resistiven Elemente C2, R2 einstellbare Werte auf, während die ersten kapazitiven und resistiven Elemente C1, R1 feste Werte aufweisen.

In einer vierten Ausführungsform der Modulationseinheit weisen sowohl die ersten als auch die zweiten kapazitiven und resistiven Elemente C1, R1, C2, R2 einstellbare Werte auf. In diesem Falle generiert die Umsetzeinheit insgesamt vier vom Modulationssignal m abhängige Potentialwerte.

In jeder der zweiten, dritten und vierten Ausführungsformen der Modulationseinheit werden die Werte der Bauelemente des Spannungsteilers 42 so eingestellt bzw. gewählt und der Potentialwert am Hochpunkt 42-1 des Spannungsteilers 42 so gewählt, daß sich die Steuerspannung vm für jeden Modulationswert (m0, m1) in einer Zeitspanne TE, die kürzer als die Zeitdauer TC des Modulationswertes ist, auf denjenigen Spannungswert (vm0, vm1) einstellt, der auf denjenigen vorgegebenen Frequenzwert (f0, f1) des Ausgangssignals yRF führt, der dem Modulationswert zugeordnet ist. Am Mittelabgriff des Spannungsteilers ergibt sich dann die oben mit Bezug auf die Figuren 3 und 4 näher beschriebene zweite Steuerspannung vm.

Sinngemäß gilt dies wiederum auch für höherstufige Modulationssignale m mit N>2 unterschiedlichen Modulationswerten.

Die erfindungsgemäßen Frequenzmodulatoren mit den vorstehend erläuterten zweiten bis vierten Ausführungsformen der Modulationseinheit sind einfach zu realisieren und energiesparend zu betreiben. Außerdem sind sie robust gegenüber Toleranzen innerhalb der Phasenregelschleife.

Obgleich die vorliegende Erfindung vorstehend anhand von Ausführungsbeispielen beschrieben wurde, ist sie nicht darauf beschränkt, sondern auf vielfältige Weise modifizierbar. So ist die Erfindung beispielsweise weder auf WPANs an sich, noch auf WPANs gemäß IEEE 802.15.4 bzw. die dort spezifizierte Modulation (Offset-QPSK bzw. MSK mit zweistufigen Modulationswerten), Frequenzbänder und -werte, Modulationsrate etc. beschränkt. Die Erfindung kann vielmehr vorteilhaft in unterschiedlichsten drahtlosen oder -gebundenen Kommunikationssystemen eingesetzt werden. Auch ist die Erfindung nicht auf eine bestimmte Referenzfrequenz, Frequenzauflösung, Datenrate oder eine bestimmte Architektur der PLL ("fractional-N"), des Schleifenfilters, des VCO, des Frequenzteilers, der Umsetzeinheit oder der Teilerbestimmungseinheit beschränkt.

Bezugszeichenliste

| | |
|---|---|
| 10 | Datenübertragungssystem / "Wireless Personal Area Network" (WPAN) nach dem IEEE-Standard 802.15.4 |
| 11-13 | Sende-/Empfangsvorrichtung (transceiver, TRX) |
| 14 | Antenne |
| 15 | Sendeeinheit (transmitter, TX) |
| 16 | Empfangseinheit (receiver, RX) |
| 17 | Kontrolleinheit (CTRL) |
| 20 | Frequenzmodulator |
| 21 | Referenzoszillator |
| 22 | Phasen(differenz)detektor / Ladungspumpe (PD/CP) |
| 23 | Schleifenfilter (loop filter, LF) |
| 24 | spannungsgesteuerter Oszillator (VCO) |
| 25 | schaltbarer Frequenzteiler (DIV) |
| 30 | Modulationseinheit (MOD) |
| 31 | Umsetzeinheit (MAP) |
| 31 a | Schaltelement |
| 31 b, 31 c | Widerstand |
| 32 | Spannungsteiler |
| 32-1, -2, -3 | Hochpunkt, Mittelabgriff bzw. Bezugspunkt des Spannungsteilers |
| 36 | Teilerbestimmungseinheit |
| 37 | FRAC/INT-Bestimmungseinheit (F/I) |
| 38 | Sigma-Delta-Modulator ($\Sigma\Delta$) |
| 39 | Addiereinheit |
| 40 | Modulationseinheit (MOD) |
| 41 | Umsetzeinheit (MAP) |
| 42 | Spannungsteiler |
| 42-1, -2, -3 | Hochpunkt, Mittelabgriff bzw. Bezugspunkt des Spannungsteilers |
| CTRL | Kontrolleinheit |
| DIV | schaltbarer Frequenzteiler |
| F/I | FRAC/INT-Bestimmungseinheit |
| FSK | frequency shift keying (diskretes Frequenzmodulationsverfahren) |

| ISM | industrial, scientific, medical (Frequenzband bei 2,4 GHz) |
|---|---|
| LF | loop filter (Schleifenfilter) |
| MAP | Umsetzeinheit |
| MOD | Modulationseinheit |
| MSK | minimum shift keying (diskretes Frequenzmodulationsverfahren) |
| PD/CP | Phasendetektor / Ladungspumpe (charge pump) |
| PLL | phase locked loop |
| QPSK | quarternary phase shift keying |
| RX | Empfangseinheit, receiver |
| TRX | Sende-/Empfangsvorrichtung, transceiver |
| TX | Sendeeinheit, transmitter |
| VCO | voltage controlled oscillator (spannungsgesteuerter Oszillator) |
| WPAN | Wireless Personal Area Network |

| $\Delta F$ | Frequenzhub |
|---|---|
| $\Sigma\Delta$ | Sigma-Delta-Modulator |
| CH | Index des gewünschten Kanals im ISM-Band |
| D | Teiler bei der Frequenzteilung |
| f0, f1 | Frequenzwerte von fRF bei zweistufiger Modulation (N=2) |
| fC | Chiptakt (=1/TC) |
| fCH | Mittenfrequenz des Kanals mit Index CH |
| fDIV | Frequenz des frequenzgeteilten Signals xDIV |
| FRAC | gebrochenrationaler Anteil des Teilers D |
| fREF | Referenzfrequenz |
| fRF | Frequenz des Ausgangssignals yRF |
| iCP | definierter Strom der Ladungspumpe |
| INT | ganzzahliger Anteil des Teilers D |
| m | Modulationssignal |
| N | Stufigkeit (der Werte) des Modulationssignals m |
| TC | Chipperiode (=1/fC) |
| vm | zweite Steuerspannung |
| vt | erste Steuerspannung |
| xDIV | frequenzgeteiltes Signal |
| xREF | Referenzsignal |
| yRF | Ausgangssignal des VCO / Frequenzmodulators |

**Patentansprüche**

1.  Frequenzmodulator (20) zum Generieren eines Ausgangssignals (yRF) mit einer von einem Modulationssignal (m) abhängigen Frequenz (fRF), wobei das Modulationssignal $N \geq 2$ unterschiedliche diskrete Modulationswerte (m0, m1) annehmen kann und jedem Modulationswert ein vorgegebener Frequenzwert (f0, f1) des Ausgangssignals (yRF) zugeordnet ist, enthaltend:

    a) eine geschlossene Phasenregelschleife mit einem Schleifenfilter (23) zum Bereitstellen einer ersten Steuerspannung (vt), einem spannungsgesteuerten Oszillator (24) zum Generieren des Ausgangssignals (yRF) und einem schaltbaren Frequenzteiler (25) zum Ableiten eines frequenzgeteilten Signals (xDIV)
    b) und eine Modulationseinheit (30; 40), die ausgebildet ist, an einem ersten Ausgang vom Modulationssignal (m) abhängige Werte eines Teilers (D) und an einem zweiten Ausgang eine vom Modulationssignal (m) abhängige zweite Steuerspannung (vm) bereitzustellen,
    c) wobei der Oszillator (24) einen mit dem Schleifenfilter (23) verbundenen ersten Steuereingang und einen mit dem zweiten Ausgang der Modulationseinheit (30; 40) verbundenen zweiten Steuereingang aufweist und ausgebildet ist, das Ausgangssignal (yRF) in Abhängigkeit von der ersten Steuerspannung (vt) und der zweiten Steuerspannung (vm) zu generieren,
    d) und wobei der Frequenzteiler (25) mit dem ersten Ausgang der Modulationseinheit (30; 40) verbunden und ausgebildet ist, das frequenzgeteilte Signal (xDIV) derart abzuleiten, daß es von den Teilerwerten (D) abhängige Momentanfrequenzen (fDIV) aufweist,
    **dadurch gekennzeichnet, dass**

e) die Modulationseinheit (30; 40) einen kapazitiven Spannungsteiler (C1, C2) mit einem Mittelabgriff (32-2; 42-2) aufweist und ausgebildet ist, die zweite Steuerspannung (vm) am Mittelabgriff (32-2; 42-2) bereitzustellen.

2. Frequenzmodulator nach Anspruch 1, **dadurch gekennzeichnet, daß** die Modulationseinheit (30; 40) einen Eingang zum Zuführen des Modulationssignals (m) aufweist, der mit dem kapazitiven Spannungsteiler (C1, C2) verbunden ist.

3. Frequenzmodulator nach Anspruch 1 oder 2, **dadurch gekennzeichnet, daß** die Modulationseinheit (30; 40) einen resistiven Spannungsteiler (R1, R2) aufweist, dessen Mittelabgriff mit dem Mittelabgriff (32-2; 42-2) des kapazitiven Spannungsteilers (C1, C2) verbunden ist.

4. Frequenzmodulator nach Anspruch 3, **dadurch gekennzeichnet, daß** der kapazitive Spannungsteiler (C1, C2) und der resistive Spannungsteiler (R1, R2) jeweils einen Hochpunkt (32-1; 42-1) aufweisen, die auf demselben Potential liegen.

5. Frequenzmodulator nach einem der vorhergehenden Ansprüche, **dadurch gekennzeichnet, daß** der kapazitive Spannungsteiler (C1, C2) ein zwischen dem Mittelabgriff (32-2; 42-2) und einem Bezugspunkt (32-3; 42-3) angeordnetes erstes kapazitives Element (C1) und ein zwischen dem Mittelabgriff (32-2; 42-2) und einem Hochpunkt (32-1; 42-1) des kapazitiven Spannungsteilers angeordnetes zweites kapazitives Element (C2) aufweist.

6. Frequenzmodulator nach Anspruch 5, **dadurch gekennzeichnet, daß** es sich beim ersten kapazitiven Element (C1) um eine parasitäre Kapazität handelt.

7. Frequenzmodulator nach Anspruch 5 oder 6, **dadurch gekennzeichnet, daß** parallel zum ersten kapazitiven Element (C1) ein erstes resistives Element (R1) und parallel zum zweiten kapazitiven Element (C2) ein zweites resistives Element (R2) geschaltet ist.

8. Frequenzmodulator nach Anspruch 7, **dadurch gekennzeichnet, daß** das erste kapazitive und das erste resistive Element (C1, R1) und/oder das zweite kapazitive und das zweite resistive Element (C2, R2) einen einstellbaren Wert aufweisen und die Modulationseinheit (40) eine Umsetzeinheit (41) aufweist, die ausgebildet ist, die einstellbaren Werte in Abhängigkeit vom jeweils aktuellen Wert des Modulationssignals (m) einzustellen.

9. Frequenzmodulator nach einem der Ansprüche 1 bis 7, **dadurch gekennzeichnet, daß** die Modulationseinheit (30) eine mit einem Hochpunkt (32-1) des kapazitiven Spannungsteilers (C1, C2) verbundene Umsetzeinheit (31) aufweist, die ausgebildet ist, jedem Modulationswert (m0, m1) einen vorgegebenen Potentialwert (vx0, vx1) zuzuordnen und denjenigen vorgegebenen Potentialwert am Hochpunkt (32-1) anzulegen, der dem jeweils aktuellen Wert des Modulationssignals (m) zugeordnet ist.

10. Frequenzmodulator nach einem der vorhergehenden Ansprüche, **dadurch gekennzeichnet, daß** die Modulationseinheit (30; 40) ausgestaltet ist, die zweite Steuerspannung (vm) für jeden Modulationswert (m0, m1) in einer ersten Zeitspanne (TE), die kürzer als die Zeitdauer (TC) des Modulationswertes ist, auf denjenigen Spannungswert (vm0, vm1) einzustellen, der auf denjenigen vorgegebenen Frequenzwert (f0, f1) des Ausgangssignals (yRF) führt, der dem Modulationswert (m0, m1) zugeordnet ist.

11. Frequenzmodulator nach einem der vorhergehenden Ansprüche, **dadurch gekennzeichnet, daß** die Modulationseinheit (30; 40) ausgestaltet ist, einen definierten Strom am Mittelabgriff (32-2; 42-2) aufzuprägen bzw. von diesem abzuführen, der so dimensioniert ist, daß die zweite Steuerspannung (vm) für jeden Modulationswert (m0, m1) in einer ersten Zeitspanne (TE), die kürzer als die Zeitdauer (TC) des Modulationswertes ist, auf denjenigen Spannungswert (vm0, vm1) eingestellt wird, der auf denjenigen vorgegebenen Frequenzwert (f0, f1) des Ausgangssignals (yRF) führt, der dem Modulationswert (m0, m1) zugeordnet ist.

12. Frequenzmodulator nach einem der vorhergehenden Ansprüche, **dadurch gekennzeichnet, daß** die Modulationseinheit (30; 40) ausgebildet ist, jedem der N Modulationswerte (m0, m1) mindestens einen Potentialwert (vx0, vx1; vxR0, vxR1, vxC0, vxC1) zuzuordnen und den- bzw. diejenigen Potentialwert(e) bereitzustellen, der/die dem jeweils aktuellen Wert des Modulationssignals (m) entspricht/entsprechen.

13. Frequenzmodulator nach einem der vorhergehenden Ansprüche, **dadurch gekennzeichnet, daß** der Oszillator (24) ein erstes und ein zweites frequenzbestimmendes kapazitives Element (Ct, Cm) mit einem einstellbaren ersten bzw. zweiten Kapazitätswert aufweist und der Frequenzmodulator ausgebildet ist, den ersten Kapazitätswert mit Hilfe der ersten Steuerspannung (vt) und den zweiten Kapazitätswert mit Hilfe der zweiten Steuerspannung (vm) einzustellen.

**14.** Frequenzmodulator nach Anspruch 13, **dadurch gekennzeichnet, daß** das zweite frequenzbestimmende kapazitive Element (Cm) parallel zum ersten frequenzbestimmenden kapazitiven Element (Ct) geschaltet ist.

**15.** Frequenzmodulator nach einem der vorhergehenden Ansprüche, **dadurch gekennzeichnet, daß** der Oszillator (24) ausgebildet ist, die erste und die zweite Steuerspannung (vt, vm) mit voneinander verschiedenen Steilheiten (K1, K2) umzusetzen.

**16.** Frequenzmodulator nach einem der vorhergehenden Ansprüche, **dadurch gekennzeichnet, daß** die Phasenregelschleife einen mit dem Frequenzteiler (25) und dem Schleifenfilter (23) verbundenen Phasendetektor (22) aufweist, der ausgebildet ist, die Phasendifferenz zwischen einem Referenzsignal (xREF) und dem frequenzgeteilten Signal (xDIV) zu bestimmen.

**17.** Frequenzmodulator nach einem der vorhergehenden Ansprüche, **dadurch gekennzeichnet, daß** der Frequenzmodulator ausgebildet ist, eine ungefilterte Modulation durchzuführen.

**18.** Frequenzmodulator nach einem der vorhergehenden Ansprüche, **dadurch gekennzeichnet, daß** die Rate (fC) des Modulationssignals (m) die Grenzfrequenz der geschlossenen Phasenregelschleife übersteigt.

**19.** Sende-/Empfangsvorrichtung (11-13), insbesondere für ein Datenübertragungssystem (10) nach dem IEEE-Standard 802.15.4, enthaltend eine Antenne (14) sowie eine mit der Antenne verbundene Sendeeinheit (15) zum Senden von Daten insbesondere nach IEEE 802.15.4, mit einem Frequenzmodulator (20) nach einem der vorhergehenden Ansprüche.

**20.** Integrierte Schaltung, insbesondere für eine Sende-/Empfangsvorrichtung nach Anspruch 19, mit einem Frequenzmodulator (20) nach einem der Ansprüche 1 bis 18.

FIG.1

FIG.2

FIG. 3

FIG. 4

FIG.5

**Europäisches Patentamt**

## EUROPÄISCHER RECHERCHENBERICHT

Nummer der Anmeldung

EP 07 00 7141

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 6 844 763 B1 (BALBONI E)<br>18. Januar 2005 (2005-01-18)<br>* Spalte 6, Zeile 53 - Spalte 10, Zeile 9;<br>Abbildungen 1-8 *<br>----- | 1-20 | INV.<br>H03C3/09 |
| X | US 4 743 867 A (SMITH J)<br>10. Mai 1988 (1988-05-10)<br>* Spalte 5, Zeile 4 - Spalte 8, Zeile 26;<br>Abbildung 3 *<br>----- | 1 | |
| X | US 2005/104669 A1 (HERZINGER S)<br>19. Mai 2005 (2005-05-19)<br>* Absatz [0028] - Absatz [0031];<br>Abbildungen 1,2 *<br>----- | 1 | |
| A | US 2003/043950 A1 (HANSEN E)<br>6. März 2003 (2003-03-06)<br>* Absatz [0031]; Abbildung 5 *<br>----- | 1-20 | |
| A | US 5 983 077 A (DENT)<br>9. November 1999 (1999-11-09)<br>* Spalte 5, Zeile 10 - Zeile 37;<br>Abbildungen 2,3 *<br>----- | 1-20 | |

**RECHERCHIERTE SACHGEBIETE (IPC)**

H03C

Der vorliegende Recherchenbericht wurde für alle Patentansprüche erstellt

| Recherchenort | Abschlußdatum der Recherche | Prüfer |
|---|---|---|
| Den Haag | 7. August 2007 | Butler, Nigel |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 07 00 7141

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

07-08-2007

| Im Recherchenbericht angeführtes Patentdokument | | Datum der Veröffentlichung | Mitglied(er) der Patentfamilie | | Datum der Veröffentlichung |
|---|---|---|---|---|---|
| US 6844763 | B1 | 18-01-2005 | US | 6967513 B1 | 22-11-2005 |
| US 4743867 | A | 10-05-1988 | KEINE | | |
| US 2005104669 | A1 | 19-05-2005 | WO | 03081868 A2 | 02-10-2003 |
| | | | DE | 10213525 A1 | 23-10-2003 |
| | | | EP | 1488508 A2 | 22-12-2004 |
| US 2003043950 | A1 | 06-03-2003 | KEINE | | |
| US 5983077 | A | 09-11-1999 | AU | 8599098 A | 22-02-1999 |
| | | | BR | 9810828 A | 25-07-2000 |
| | | | CA | 2296309 A1 | 11-02-1999 |
| | | | CN | 1265785 A | 06-09-2000 |
| | | | DE | 69811084 D1 | 06-03-2003 |
| | | | DE | 69811084 T2 | 17-07-2003 |
| | | | EP | 1000461 A1 | 17-05-2000 |
| | | | JP | 2001512912 T | 28-08-2001 |
| | | | WO | 9907065 A1 | 11-02-1999 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- *IEEE Transactions on Circuits and Systems - II: Analog and Digital Signal Processing,* Mai 2002, vol. 49 (5), 301-311

- **CHRISTIAN COJOCARU.** A 43mW Bluetooth Transceiver with -91dBm Sensitivity. *2003 IEEE International Solid-State Circuits Conference,* 64, 65, 432